# EUROPÄISCHE PATENTSCHRIFT

(11) **EP 0 372 440 B1**
(45) Veröffentlichungstag und Bekanntmachung des Hinweises auf die Patenterteilung: **22.02.1995**
(21) Anmeldenummer: 89122275.4
(22) Anmeldetag: 02.12.1989
(51) Int. Cl.: H03H 17/02

(54) **Digitales Filter**
Digital filter
Filtre numérique

(30) Priorität: 08.12.1988 DE 3841268
(43) Veröffentlichungstag der Anmeldung: 13.06.1990
(73) Patentinhaber: Deutsche Thomson-Brandt GmbH, 78003 Villingen-Schwenningen (DE)
(72) Erfinder: Klank, Otto, D-3160 Lehrte-Arpke (DE); Rottmann, Dieter, D-3000 Hannover 61 (DE)

(56) Entgegenhaltungen:
- FR-A- 2 276 635
- N.T.Z.-ARCHIV, Band 7, Nr. 3, März 1985, Seiten 47-57, Berlin, DE; H. GÖCKLER:"Einstellbare Digitalfilter für die Tontechnik"
- TELECOMMUNICATIONS AND RADIO ENGINEERING, Band 39/40, Nr. 8, August 1985,Seiten 93-96, Scripta Technica, Inc., Silver Spring, Maryland, US; S.B. MAKAROVet al.: "Optimizing the structure of nonrecursive digital filter"

## Beschreibung

Die Erfindung betrifft ein Filter für digital übertragene Nachrichtensignale. Solche Signale können beispielsweise der digitalen Übertragung von Audio-Informationen dienen.

Bei der drahtlosen Übertragung von Nachrichtensignalen können durch Mehrwege-Empfang Auslöschungen von Signalbestandteilen auftreten. Es ist bekannt, solche Störungen durch geeignete Formung des Signalaufbaus in Verbindung mit entsprechenden Signalverarbeitungs-Maßnahmen im Empfänger und/oder durch Wahl der Senderfrequenzen zu verringern.

Bei stationär betriebenen Empfängern ist es nur erforderlich, eine optimale Einstellung des Empfängers auf die jeweilige Empfangssituation einmal, z.B. nach jedem Einschalten, vorzunehmen. Bei Empfängern, die in Kraftfahrzeugen betrieben werden, ist jedoch eine laufende Anpassung an die schnell sich ändernden Empfangsverhältnisse erforderlich. Hierzu kann z.B. eine Testsequenz periodisch übertragen und durch Korrelation im Empfänger ausgewertet werden. Das Ergebnis liefert dann die Einstellgrößen für ein in den Signalweg zu schaltendes (adaptives) Filter. Solche Verfahren sind z.B. in folgenden Abhandlungen beschrieben: G.D. Forney, Jr. "Training adaptive linear filters", U.S. Patent No. 3,723,911 March 27, 1973.
K.H. Mueller and D.A. Spaulding, "Cyclic equalization - a new rapidly converging equalization technique for synchronous data communication", Bell System. J. pp 369-406, Feb. 1975.

In FR-A-2276635 werden zur schnellen Multiplikation vielstellige Binärzahlen diese in z.B. 8-stellige Zahlen aufgeteilt, führende und schleppende Nullen unterdrückt und anschließend Mantisse und Exponent geformt. Alle von Null verschiedenen Zahlen werden bei der Multiplikation verwendet.
In H. Göckler, "Einstellbare Digitalfilter für die Tontechnik", N.T.Z.-ARCHIV, Seiten 47-57, Band 7, Nr.3, März 1985, sind FIR-Filter mit Verwendung von Verzögerungsgliedern beschrieben.

Die in diesen Abhandlungen beschriebenen adaptiven Verfahren erfordern einen sehr großen technischen Aufwand, der z.B. durch einen Rechner (Signalprozessor) mit entsprechendem Leistungsvermögen erbracht werden kann.

Zur Lösung der Aufgabe wird allgemein eine Filteranordnung verwendet, die mittels eines Schieberegisters und eines Rechners kontinuierlich an sich ändernde Empfangsbedingungen anpaßbar ist. Die "zu filternde" Nachricht besteht z.B. aus einer Aufeinanderfolge von digital codierten Werten mit je 8 Bit und wird fortlaufend dem Schieberegister zugeführt. Das Schieberegister ist so bemessen, daß z.B. mindestens 1024 Werte mit je 8 bit gespeichert werden können. Unter Ausnutzung dieser großen Länge von z.B. 1024 Werten wird zu jedem dieser einzelnen Werte mittels eines Rechners, z.B. eines Signalprozessors, nach vorbestimmtem mathematischem Gesetz ein neuer Ausgangswert berechnet. Der neue vom Rechner ermittelte Ausgangswert hängt also von 1024 Einzelwerten ab. Über diese Länge der Information, im allgemeinen auch über noch größere Längen von z.B. mehreren 1000 Werten, kann das vorgesehene mathematische Gesetz für jeden neuen Ausgangswert als konstant angesehen werden. Nach Ablauf der vorgegebenen Länge von z.B. 1024 Werten oder nach Ablauf von noch größeren Längen von z.B. mehreren Blöcken a 1024 bit muß das dem Filter zugeordnete mathematische Bildungsgesetz für die Berechnung der neuen Ausgangswerte geändert werden.

Da die Vorgänge bereits für jeden Ausgangswert einen großen Rechenaufwand von z.B. 1024 8Bit-Multiplikationen jeweils mit Aufsummierung erfordern, andererseits aber die Prozeßzeit heutiger Signalprozessoren wesentlich unter der für einen Multiplikationsvorgang verfügbaren Zeit liegt, erfolgt die Berechnung auch für den einzelnen Ausgangswert zweckmäßigerweise seriell, wobei durch Zwischenumläufe des Schieberegisters die entsprechenden Basiswerte zur Verfügung gestellt werden. Im gewählten Beispiel beträgt die für die Berechnung der größeren Länge (Serie) von Daten zur Verfügung stehende Zeit einige Millisekunden, d.h. ca. 1000 Ausgangswerte müssen in ca. 1 ms berechnet werden, was wiederum ca. 1000 Multiplikationen (je Ausgangswert) in 1 »s bedeutet. Dies kann auch von den derzeit besten Prozessoren nicht geleistet werden, auch ist eine solche Datenfolge nicht aus einem Schieberegister auslesbar. Da die Prozeßzeit für eine Multiplikation z.B. 25 ns beträgt, müßte eine entsprechend große Zahl von Prozessoren parallelgeschaltet werden, um die Aufgabe zu erfüllen, was jedoch aus Kosten- und anderen praktischen Gründen für Geräte der Konsumgütertechnik ausscheidet.

Der Erfindung liegt die Aufgabe zugrunde, eine für Konsumempfänger praktikable Filteranordnung anzugeben, die an sich sehr schnell ändernde Empfangsbedingungen anpaßbar ist. Diese Aufgabe wird durch die im Anspruch 1 gekennzeichnete Erfindung gelöst. Weiterbildungen der Erfindung sind in den Unteransprüchen beschrieben.

Zur näheren Erläuterung wird im folgenden die Erfindung anhand von Ausführungsbeispielen beschrieben. Diese zeigen in
- Fig. 1: ein digitales Filter,
- Fig. 2: ein Schaltungsbeispiel,
- Fig. 3: ein Beispiel mit simultaner Berechnung,
- Fig. 4: ein weiteres Schaltungsbeispiel.

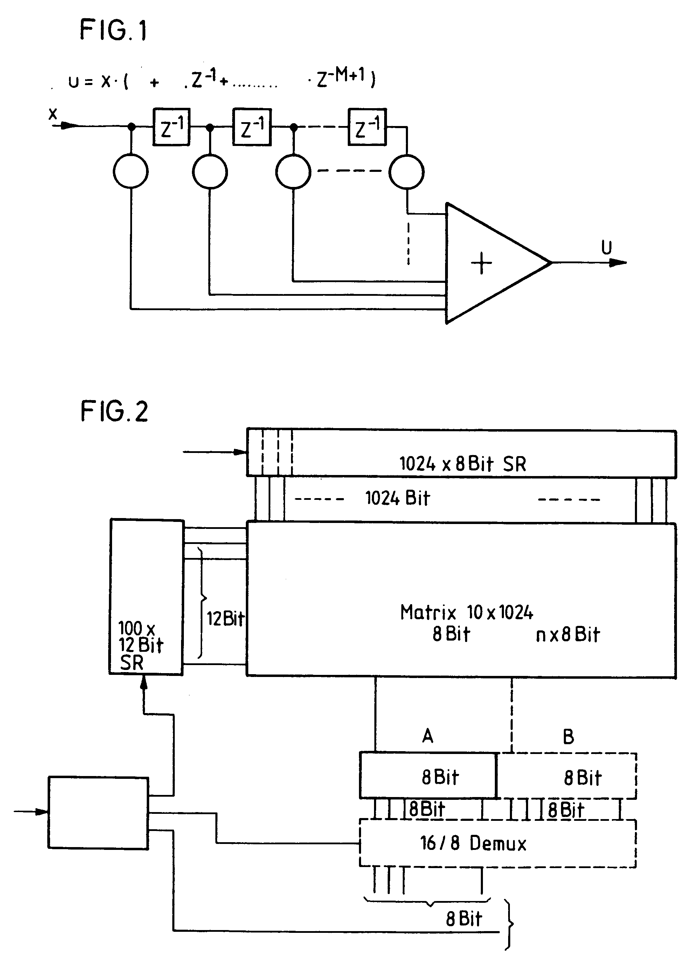

Figur 1 zeigt den prinzipiellen Aufbau eines Transversal-Filters, das für die Lösung der vorstehend beschriebenen Aufgabe geeignet ist. Einem Schieberegister 1 werden die Daten eines digital codierten Nachrichtensignals zugeführt. Das Ausgangssignal wird durch Multiplikation der einzelnen Schieberegister-Ausgangssignale mit bestimmten Koeffizienten (C1 ... Cn) und Addition gebildet.

Fig. 2 zeigt ein Ausführungsbeispiel der Erfindung, bei dem eine serielle Berechnung mit nur einem Prozessor angestrebt wird. Um dies zu erreichen, wird die Tatsache genutzt, daß die für einen Ausgangswert durchzuführenden Multiplikationen unterschiedliche Beiträge zum Ausgangswert liefern (entsprechend Multiplikatoren bzw. Koeffizienten von z.B. 0 bis 1). In einem "Vorprozeß" werden dazu alle Produkte mit einem Multiplikator von 0 grundsätzlich aussortiert, weil sie keinen Beitrag zur Produkt-Summe liefern. Die verbleibende Anzahl der Werte wird der Größe nach geordnet und auf eine bestimmte, vorher festgelegte Anzahl von z.B. 50 (aus 1024) begrenzt.

Die Schaltung enthält wiederum ein Speicherschieberegister von entsprechender Länge, z.B. 1024 Werte à 8 bit. Da die für die Berechnung zu benutzenden Werte nun beliebig über das Register verteilt sind, können die betreffenden Werte nicht mehr ohne weiteres durch Schiebevorgänge des Registers zur Verfügung gestellt werden. Das würde nämlich die an die Technologie des Schieberegisters zu stellenden Anforderungen unnötig erhöhen. Die einzelnen Schieberegisterzellen werden daher mit einer Schaltmatrix (Gatternetzwerk) verbunden, so daß entsprechende Gruppen von Schieberegisterausgängen zu einer entsprechenden Anzahl von Ausgängen der Matrix durchgeschaltet werden können. Die Schaltmatrix wird mit der in vorher beschriebener Weise ermittelten Adressenfolge gesteuert, wobei innerhalb des Berechnungsvorgangs für einen Ausgangswert die Reihenfolge beliebig sein kann, weil alle Produkte zu einer Summe zusammengefaßt werden.

Die 8Bit-Werte sind seriell einem Ausgang des Schieberegisters bzw. dem Eingang der Matrix 3 zugeordnet, so daß die Übertragung eines Wertes seriell erfolgt. Wie in Fig. 1 kann es zur Anpassung an den Rechenvorgang im Prozessor vorteilhaft sein, einen Teil der Werte am Ausgang der Matrix zwischenzuspeichern (Register A, B usw.). Dazu ist ggf. die Matrix entsprechend zu erweitern.

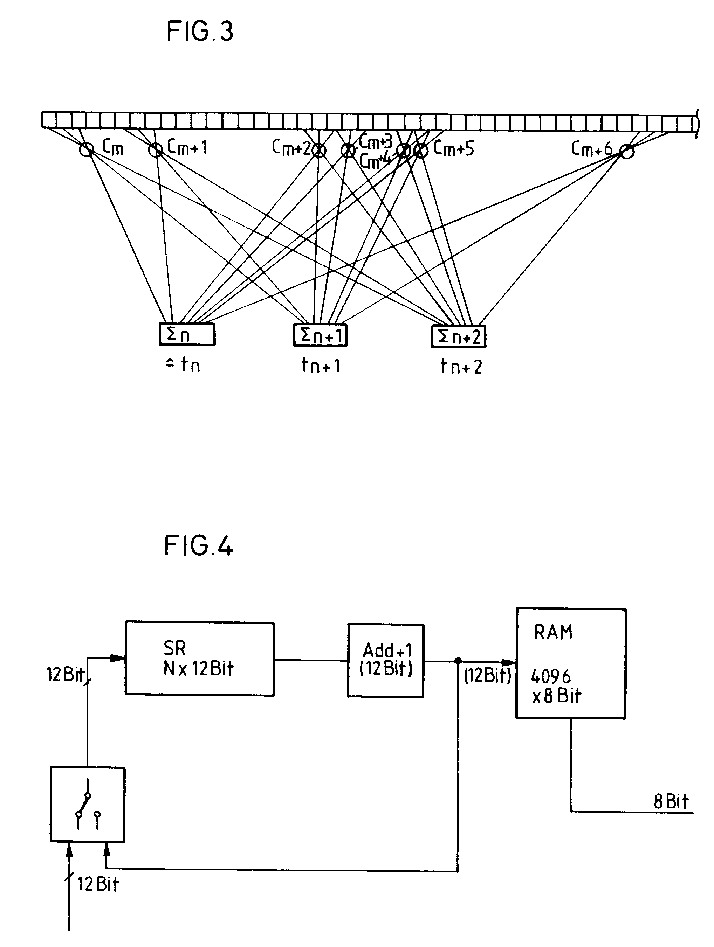

Fig. 3 zeigt, wie die Berechnung für mehrere Ausgangswerte simultan durchgeführt wird. Der Prozessor arbeitet abwechselnd in mehrere Summenspeicher (Akkumulatoren). Gezeigt ist die Zuordnung der Werte im Rechenprozeß. Die Vorteile liegen darin, daß jeweils benachbarte Zellen des Schieberegisters zu Blöcken zusammengefaßt und durch Teilumläufe seriell ausgelesen werden können; ferner, daß die Multiplikatoren im Prozessor für die zusammengefaßte Wertegruppe konstant gehalten werden können. Für eine neue Wertegruppe wird das Schieberegister um eine Blocklänge weitergeschoben.

Fig. 4 zeigt ein weiteres Ausführungsbeispiel, bei dem die Funktion des Speichers von einem RAM-Baustein (Random Access Memory) mit entsprechend niedriger Zugriffszeit übernommen wird. In dem Fall ist durch eine Adreßvorausberechnung und -steuerung sicherzustellen, daß die benötigten Speicherinhalte zum Ausgang gelangen. Die theoretisch erforderliche Adreßzahl entspricht der Anzahl der Konstanten (Koeffizienten; im gewählten Beispiel 50) multipliziert mit der Anzahl der für einen Abschnitt mit konstanten Koeffizienten zeitlich nacheinander zu berechnenden Ausgangswerte. Dies würde bei z.B. 2000 Ausgangswerten 100.000 zu berechnende Adressen ergeben. In vorteilhafter Weise kann bei entsprechender Anordnung der Werte im RAM-Baustein (analog zum Schieberegister) von einem einzigen (ersten) Adressensatz, 50 im gewählten Beispiel, ausgegangen werden und in einem einfachen Rechenvorgang können für jeden neuen Ausgangswert sämtliche Adressen jeweils um 1 erhöht oder bei umgekehrter Reihenfolge im Speicher um 1 vermindert werden.

Im Prinzip muß im RAM-Speicher die gesamte Information, für die das Bildungsgesetz der Ausgangswerte konstant ist, verfügbar gehalten werden, da ein Nachladen bei einer einmal gewählten Reihenfolge den Austausch des gesamten Speicherinhalts bedeuten und den Rechenablauf stören würde. Natürlich könnten auch die nicht mehr benötigten Teile der Information, ähnlich wie beim Schieberegister entfallen und laufend durch neu hinzukommende ersetzt werden. Ein Nachteil wäre jedoch, daß beim RAM dann die Reihenfolge (bezogen auf die Adressen) nicht mehr harmonisch ist, und somit eine kompliziertere Adressenberechnung durchgeführt werden muß.

Bei einem Empfänger kann es notwendig sein, mit mehreren Signalen, z.B. dem I- und Q-Signal bei 4PSK-Demodulation, eine Filterung durchzuführen. Außerdem können sich mehrere verschiedene Filterungsprozesse ergeben, z.B. ein sogen. Matched-Filter-Prozeß und ein Equalizer-Prozeß. Sofern es die Rechenkapazität des Prozessors zuläßt, werden die einzelnen Prozesse kombiniert (I und Q) oder ggf. zeitlich nacheinander vom gleichen Prozessor ausgeführt (Matched Filter und Equalizer). Im Fall der I- und Q-Signale sind zwei parallel laufende Speicherregister vorzusehen. Berechnete Zwischenwerte sind in einem Zwischenspeicher festzuhalten, z.B. die Ausgangswerte des Matched Filters, um damit den Equalizervorgang durchführen zu können.

## Patentansprüche

1. Digitales Filter für digital codierte Nachrichtensignale, insbesondere Audiosignale, mit einem Schieberegister (SR) zur Speicherung der digitalen Signalwerte, einem Rechner für die Berechnung neuer Ausgangswerte vorgegebener Länge für jeden Signalwert und einer Schaltung zur Ermittlung der Koeffizienten für das digitale Filter, **gekennzeichnet durch**:
- einen Vorprozeß zur Aussortierung von Signalwerten oder Koeffizienten für alle solche Signalwert-Koeffizienten-Produkte, bei denen ein Multiplikator '0' oder annähernd '0' vorgesehen ist;
- eine Sortierung der verbleibenden Koeffizienten entsprechend ihrer Größe;
- eine Begrenzung der Anzahl der sortierten Koeffizienten auf eine vorgegebene Anzahl,
wobei insbesondere ein Korrelator zur Ermittlung von Übertragungseigenschaften zur Ermittlung der Koeffizienten für das digitale Filter dient.

2. Digitales Filter nach Anspruch 1, **dadurch gekennzeichnet**, daß die einzelnen Schieberegisterzellen mit einer Schaltmatrix so verbunden sind, daß entsprechende Gruppen von aufeinanderfolgenden Zellen zu einer entsprechenden Anzahl von Ausgängen durchschaltbar sind und die an den Ausgängen verfügbaren Ausgangssignale einem Signalprozessor zugeführt werden.

3. Digitales Filter nach Anspruch 1 oder 2, **dadurch gekennzeichnet**, daß die Schaltmatrix und der Signalprozessor synchron von einem Vorprozessor gesteuert werden.

4. Digitales Filter nach einem der Ansprüche 1 bis 3, **dadurch gekennzeichnet**, daß die oder ein Teil der Werte am Ausgang der Schaltmatrix zwischengespeichert werden, um mehrere Berechnungen nacheinander ohne Schiebevorgang durchführen zu können.

5. Digitales Filter nach Anspruch 4, **dadurch gekennzeichnet**, daß die Ausgangssignale nacheinander mit den gleichen Koeffizienten berechnet und jeweils in verschiedenen Ausgangsregistern oder Akkumulatoren addiert werden.

6. Digitales Filter nach einem der Ansprüche 2 bis 5, **dadurch gekennzeichnet**, daß anstelle von Schieberegister und Matrix ein RAM und ein Adreßspeicher verwendet werden und durch einen zyklischen Umlauf des Adreßspeichers die Adressen bereitgestellt und bei jedem Umlauf um '1' erhöht werden.

## Claims

1. Digital filter for digitally coded communication signals, especially audio signals, including a shift register (SR) for storing the digital signal values, a computer for calculating new output values of predetermined length for each signal value and a circuit for determining the co-efficients for the digital filter, characterised by,
- a preliminary process for sorting out signal values or coefficients for all such signal value - co-efficients - products for which a multiplier of "0" or approximately "0" is provided;
- a sorting of the remaining co-efficients in accordance with their magnitude;
- a limiting, of the number of the sorted co-efficients, to a predetermined number,
wherein, in particular, a correlator serves for determining the transmission properties for determining the co-efficients for the digital filter.

2. Digital filter in accordance with Claim 1, characterised in that, the individual cells of the shift register are connected to a switching matrix in such a way that corresponding groups of successive cells can be switched through to a corresponding number of outputs and the output signals available at the outputs are supplied to a signal processor.

3. Digital filter in accordance with Claim 1 or 2, characterised in that, the switching matrix and the signal processor are synchronously controlled by a pre-processor.

4. Digital filter in accordance with any of the Claims 1 to 3, characterised in that, the or a part of the values at the output of the switching matrix are buffer stored in order to be able to carry out a plurality of calculations, one after the other, without a shifting process.

5. Digital filter in accordance with Claim 4, characterised in that, the output signals are calculated, one after the other, using the same co-efficients and are respectively added in different output registers or accumulators.

6. Digital filter in accordance with any of the Claims 2 to 5, characterised in that, a RAM and an address store are used instead of a shift register and a matrix and the addresses are made available during a cyclic cycle of the address store and are increased by "1" at each cycle.

## Revendications

1. Filtre numérique pour des signaux d'information codés en numérique, en particulier des signaux son, avec un registre à décalage (SR) pour la mise en mémoire des valeurs de signal numériques, un ordinateur pour le calcul de nouvelles valeurs de sortie d'une longueur prédéfinie pour chaque valeur de signal et un circuit pour déterminer les coefficients pour le filtre numérique, **caractérisé par :**
- un processus préliminaire pour trier des valeurs de signal ou des coefficients pour tous les produits de coefficients et de valeurs de signal pour lesquels un multiplicateur '0' ou approximativement '0' est prévu ;
- un tri des coefficients qui restent selon leur grandeur ;
- une limitation du nombre des coefficients triés à un nombre prédéfini,
un corrélateur servant en particulier à déterminer des qualités de transmission pour déterminer les coefficients pour le filtre numérique.

2. Filtre numérique selon la revendication 1, **caractérisé en ce** que les différentes cellules du registre à décalage sont liées à une matrice de commutation de telle manière que des groupes correspondants de cellules successives peuvent être commutés sur un nombre correspondant de sorties et les signaux de sortie disponibles aux sorties sont amenés à un processeur de signaux.

3. Filtre numérique selon la revendication 1 ou 2, **caractérisé en ce** que la matrice de commutation et le processeur de signaux sont commandés de manière synchrone par un préprocesseur.

4. Filtre numérique selon l'une des revendications 1 à 3, **caractérisé en ce** que les valeurs ou une partie des valeurs sont mémorisées temporairement à la sortie de la matrice de commutation pour pouvoir effectuer plusieurs calculs l'un après l'autre sans opération de décalage.

5. Filtre numérique selon la revendication 4, **caractérisé en ce** que les signaux de sortie sont calculés l'un après l'autre avec les mêmes coefficients et sont additionnés respectivement dans différents registre de sortie ou accumulateurs.

6. Filtre numérique selon l'une des revendications 2 à 5, **caractérisé en ce** qu'à la place du registre à décalage et de la matrice on utilise une mémoire vive et une mémoire d'adresses et que les adresses sont mises à disposition par une rotation cyclique de la mémoire d'adresses et qu'elles sont augmentées d' '1' à chaque rotation.
